Europäisches Patentamt

European Patent Office

Office européen des brevets

(19)

(11) Veröffentlichungsnummer: **0 060 968**
B1

(12) **EUROPÄISCHE PATENTSCHRIFT**

(45) Veröffentlichungstag der Patentschrift:
06.08.86

(21) Anmeldenummer: 82100205.2

(22) Anmeldetag: 14.01.82

(51) Int. Cl.⁴: **G 02 F 1/133, B 23 K 1/20,
B 32 B 15/00, B 23 K 35/00**

(54) Lötfähiges Schichtensystem.

(30) Priorität: 20.03.81 DE 3110978

(43) Veröffentlichungstag der Anmeldung:
29.09.82 Patentblatt 82/39

(45) Bekanntmachung des Hinweises auf die Patenterteilung:
06.08.86 Patentblatt 86/32

(84) Benannte Vertragsstaaten:
FR GB IT NL SE

(56) Entgegenhaltungen:
EP - A - 0 044 906
CH - A - 557 071

IBM TECHNICAL DISCLOSURE BULLETIN, Band 20, Nr.
6, November 1977, Seite 2314, New York, US G.
DIGIACOMO: "Passivation of lead/indium solder pads"
IBM Techn. Discl. Bull. 18 (1975), S. 1759

(73) Patentinhaber: VDO Adolf Schindling AG,
Gräfstrasse 103, D-6000 Frankfurt/Main (DE)

(72) Erfinder: Nickol, Friedrich Wilhelm, Am Honigbaum 35,
D-6239 Eppstein (DE)

(74) Vertreter: Könekamp, Herbert, Dipl.-Ing., Sodener
Strasse 9, D-6231 Schwalbach (DE)

**Beschreibung**

Die Erfindung bezieht sich auf ein Verfahren zum Aufbringen einer nicht lötfähigen Leiterschicht und Herstellen einer lötfähigen Anschlussstelle hierfür auf einen(m) Träger, bei dem auf die Leiterschicht ein korrosionsstabiles Schichtensystem, bestehend aus einer Kupfer oder Eisen enthaltenden Lötschicht und einer diese überdeckenden und gegen Oxidation schützenden Korrosionsschutzschicht aufgebracht wird.

Bei einem derartigen beschriebenen Schichtensystem (ältere europäische Anmeldung EP-A-44 906) soll durch die Korrosionsschutzschicht eine Oxidation der Lötschicht, die vorzugsweise aus Kupfer oder Eisen besteht, verhindert werden. Diese Korrosionsschutzschicht, die aus einem korrosiven Metall besteht, überdeckt die Lötschicht und wird in einem Hochtemperaturprozess durchoxidiert.

Zum Aufbringen der Korrosionsschutzschicht ist ein besonderer Arbeitsgang erforderlich.

Aus der CH-A-557 071 ist eine Schichtensystem bekannt, bei dem auf einen Träger nicht lötfähige Leiter aufgebracht sind, die mit einer lötfähigen Anschlussstelle versehen werden, damit ein Lötanschluss möglich ist.

Die lötfähige Anschlussstelle besteht dabei aus einem Schichtensystem, das zuerst eine auf die nicht lötfähige Leiterschicht aufgebrachte Kontaktschicht aus Aluminium besitzt, auf welche anschliessend eine lötfähige Metallschicht aus Chrom-Kupfer-Gold oder Chrom-Nickel-Gold aufgebracht wird. Dabei dient das Chrom als Haftschicht und Kupfer bzw. Nickel stellen die eigentlichen Lötschichten dar. Der Goldbelag ist abschliessend als Schutzschicht vorgesehen.

Aus der «IBM Technical Disclosure Bulletin» 18 (1975), Seite 1759 ist ein eine lötfähige Anschlussstelle bildendes Schichtensystem bekannt, das aus einer Lötschicht und eine diese überdeckenden und gegen Oxidation schützenden Korrosionsschutzschicht besteht. Die Korrosionsschutzschicht wird in einer Temperaturbehandlung durch Oxidation von in der Lötschicht enthaltenem korrosiven Metall an der freien Oberfläche der Lötschicht gebildet.

Es ist Aufgabe der Erfindung, ein Verfahren nach dem Oberbegriff zu schaffen, das einfacher und kostengünstiger ist.

Diese Aufgabe wird erfindungsgemäss dadurch gelöst, dass zunächst die Leiterschicht nur teiloxidiert aufgebracht wird, dass die Lötschicht einen Anteil aus korrosivem Metall enthält, dass bei der zum Durchoxidieren der Leiterschicht erfolgenden Hochtemperaturbehandlung an der freien Oberfläche der Lötschicht durch Oxidation des korrosiven Metalls eine Korrosionsschutzschicht gebildet wird, die die Lötschicht bei der genannten Hochtemperaturbehandlung schützt, und dass diese Korrosionsschutzschicht vor Beginn des Lötvorgangs entfernt wird. Durch den Anteil an korrosivem Metall bildet sich an der freien Oberfläche der Lötschicht die Korrosionsschutzschicht. Es ist somit kein besonderer Arbeitsgang zum Auftragen einer Korrosionsschutzschicht erforderlich. Dies führt neben der Einsparung an Arbeitszeit auch zu einer Einsparung der für ein Auftragen einer besonderen Korrosionsschutzschicht erforderlichen Vorrichtungen.

Vorzugsweise weist das korrosive Metall Anteile von Aluminium und/oder Chrom und/oder Indium und/oder Titan und/oder Zinn auf.

Ausführungsbeispiele der Erfindung sind in der Zeichnung dargestellt und werden im folgenden näher beschrieben. Es zeigen:

Fig. 1 ein erstes Ausführungsbeispiel eines erfindungsgemässen Schichtensystems,

Fig. 2 ein zweites Ausführungsbeispiel eines erfindungsgemässen Schichtensystems.

Die in den Figuren dargestellten lötfähigen Schichtensysteme 3 und 3' sind auf einen Träger 1 aus Glas aufgetragen, der als eine Wand einer Flüssigkristallzelle dient.

Auf den Träger 1 ist mit einer Dicke von vorzugsweise 250 – 1500 Å eine Leiterschicht aufgetragen, die aus Indiumzinnoxyd bestehen kann. Für diese nicht lötfähige Leiterschicht 2 bilden die Schichtensysteme 3 und 3' lötfähige Anschlussstellen, über die z.B. die Anschlüsse von als Chip ausgebildeten, integrierten Schaltkreisen an die Leiterschicht 2 anschliessbar sind.

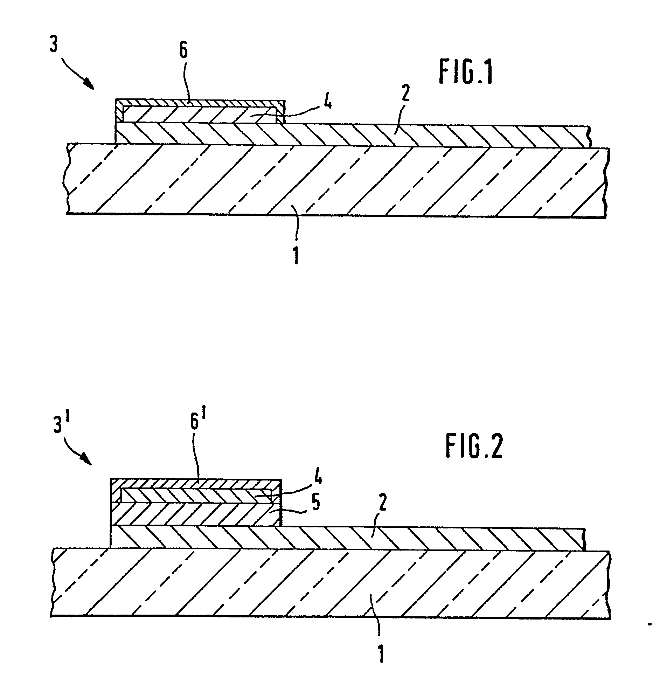

Bei dem in Fig. 1 dargestellten Schichtensystem 3 ist eine aus Kupfer oder Eisen mit Anteilen von z.B. Indium und Zinn bestehende Lötschicht 4 auf die Leiterschicht 2 direkt aufgebracht, während in Fig. 2 zwischen der Lötschicht 4 und der Leiterschicht 2 noch eine die Haftung auf dem Träger 1 verstärkende Haftvermittlerschicht 5 aus Chrom, Titan oder Aluminium angeordnet ist.

Zum Schutz der Lötschicht 4 gegen Oxidation ist diese an ihrer freien Oberfläche mit einer Korrosionsschutzschicht 6 bzw. 6' versehen.

Diese Korrosionsschutzschicht 6 bzw. 6' ist dadurch gebildet, dass das auf dem Träger 1 aufgebrachte Schichtensystem einem Hochtemperaturprozess unterworfen wird und dabei das Indium und Zinn im periphären Bereich der Lötschicht 4 oxidiert.

Ein Wegoxidieren der Lötschicht 4 ist durch die schützende Korrosionsschutzschicht 6 bzw. 6' nicht mehr möglich.

Auf die erfindungsgemässe Weise wird somit ohne wesentlichen Aufwand ein Korrosionsschutz der Lötschicht 4 erreicht.

Eine genaue definierte Dicke der Korrosionsschutzschicht 6 bzw. 6' kann durch die entsprechende Wahl der Temperatur und über die Dauer des Hochtemperaturprozesses erreicht werden.

**Patentansprüche**

1. Verfahren zum Aufbringen einer nicht lötfähigen Leiterschicht und Herstellen einer lötfähigen Anschlussstelle hierfür auf einen(m) Träger, bei dem auf die Leiterschicht ein korrosionsstabiles Schichtensystem, bestehend aus einer Kupfer oder Eisen enthaltenden Lötschicht und einer diese überdeckenden und gegen Oxidation schützenden Korrosionsschutzschicht aufgebracht wird, dadurch gekennzeichnet, dass zunächst die Leiterschicht (2) nur teiloxidiert aufgebracht wird, dass die Lötschicht (4) einen Anteil aus korrosivem Metall enthält, dass bei der zum Durchoxidieren der Leiterschicht erfolgenden Hochtemperaturbehandlung an der freien Oberfläche der Lötschicht (4) durch Oxidation des korrosiven Metalls eine Korrosionsschutzschicht (6, 6') gebildet wird, die die Lötschicht bei der genannten Hochtemperaturbehandlung schützt, und dass diese Korrosionsschutzschicht vor Beginn des Lötvorgangs entfernt wird.

2. Verfahren nach Anspruch 1, dadurch gekennzeichnet, dass das korrosive Metall Anteile von Aluminium und/oder Chrom und/oder Indium und/oder Titan und/oder Zinn aufweist.

## Claims

1. Method of applying a non-weldable conductor layer on to and producing a weldable connection point therefor on a support, wherein there is applied to the conductor layer a corrosionstable layer system consisting of a welding layer containing copper or iron and of a corrosion-protective layer which covers said welding layer and protects against oxidation, characterised in that the conductor layer (2) is applied only partly oxidised in the first instance, that the welding layer (4) includes a corrosive metal content, that at the high-temperature treatment which is carried out for through oxidation of the conductor layer there is formed at the free surface of the welding layer (4) by oxidation of the corrosive metal a corrosion-protective layer (6, 6') which protects the welding layer in the aforesaid high-temperature treatment, and that this corrosion-protective layer is removed before the welding operation begins.

2. Method according to claim 1, characterised in that the corrosive metal includes contents of aluminium and/or chromium and/or indium and/or titanium and/or tin.

## Revendications

1. Procédé pour appliquer une couche conductrice non soudable et réaliser pour elle un emplacement de connexion soudable, sur son support selon lequel on applique sur la couche conductrice un système de couches stables à la corrosion, consistant en une couche de soudure contenant du cuivre ou du fer et une couche de protection contre la corrosion, qui recouvre cette couche et la protège contre l'oxydation, procédé caractérisé en ce qu'on applique tout d'abord la couche conductrice (2) à l'état partiellement oxydé seulement, en ce que la couche de soudure (4) contient une certaine proportion de métal corrosif, en ce qu'on forme, lors du traitement à température élevée réalisé pour oxyder complètement la couche conductrice, à la surface libre de la couche de soudure (4) et par oxydation du métal corrosif une couche (6, 6') de protection contre la corrosion qui protège la couche de soudure lors du traitement précité à température élevée, et en ce qu'on enlève, avant le début du processus de soudure, cette couche de protection contre la corrosion.

2. Procédé selon la revendication 1, caractérisé en ce que le métal corrosif présente une teneur en aluminium et/ou en chrome et/ou en indium et/ou en titane et/ou en étain.

FIG.1

FIG.2